# EUROPÄISCHE PATENTSCHRIFT

(11) **EP 0 460 251 B1**
(45) Veröffentlichungstag und Bekanntmachung des Hinweises auf die Patenterteilung: **18.11.1998**
(21) Anmeldenummer: 90110611.2
(22) Anmeldetag: 05.06.1990
(51) Int. Cl.: H01L 21/336, H01L 29/06, H01L 29/772

(54) **Herstellverfahren für einen Leistungs-MISFET**
Method of fabricating a power-MISFET
Méthode de fabrication d'un MISFET de puissance

(43) Veröffentlichungstag der Anmeldung: 11.12.1991
(73) Patentinhaber: SIEMENS AKTIENGESELLSCHAFT, 80333 München (DE)
(72) Erfinder: Strack, Helmut, Dr. phil., D-8000 München 40 (DE)

(56) Entgegenhaltungen:
- EP-A- 0 227 894
- EP-A- 0 241 059
- EP-B- 0 077 481
- DE-C- 270 387
- GB-A- 2 087 648
- US-A- 4 055 884
- PATENT ABSTRACTS OF JAPAN, Band 10, Nr. 332 (E-453)[2388], 12. November 1986; & JP-A-61 137 368 (HITACHI LTD) 25-06-1986
- 'Modern Power Devices', B.J. Baliga, John Wiley & Sons, New York, 1987, pp. 116-119

## Beschreibung

Die Erfindung bezieht sich auf ein Verfahren zum Herstellen eines Leistungs-MISFET mit einem Halbleiterkörper, der ein Feld von Transistorzellen sowie mindestens eine Feldplatte und mindestens einen Kanalstopper aufweist.

Solche Transistorrandstrukturen sind beispielsweise aus Baliga, Modern Power Devices, John Wiley & Sons, Incorporation, 1987, Seite 116 ff. bekannt.

Verfahren zum Herstellen solcher MISFET sind gängige Praxis. Dabei werden wenigstens vier, meistens jedoch fünf oder mehr Fotoschritte benötigt, um die feinen Strukturen eines solchen Leistungs-MISFET herzustellen. Für jeden Fotoschritt wird eine Maske benötigt. Eine signifikante Reduzierung der Herstellkosten läßt sich nur durch Verminderung der Fotoschritte erreichen.

Der Erfindung liegt die Aufgabe zugrunde, ein für einen Niedervolt-Leistungs-MISFET verwendbares Verfahren anzugeben, das mit lediglich drei Fotoschritten auskommt.

Dieses Verfahren ist gekennzeichnet durch die Schritte:
a) Der Halbleiterkörper mit einem ersten Leitfähigkeitstyp wird mit einer ersten Oxidschicht bedeckt, die als Gateoxid dient;
b) die erste Oxidschicht wird mit einer Polysiliziumschicht bedeckt;
c) in die Polysiliziumschicht werden Öffnungen für die Transistorzellen und eine am Rand liegende Öffnung für den Kanalstopper durch einen ersten Fotoschritt strukturiert;
d) Sourcezonen (6) der Transistorzellen (8) und am Rand (4) des Halbleiterkörpers liegende erste Zonen (16) einer erstes Leitfähigkeitstyps werden mit einer ersten Implantationsdosis erzeugt, und Basiszonen (7) der Transistorzellen (8) und am Rand (4) des Halbleiterkörpers liegende zweite Zonen (16) eines zweiten zum ersten Leitfähigkeitstyp entgegengesetzten Leitfähigkeitstyps werden mit einer zweiten Implantationsdosis erzeugt, wobei die strukturierte Polysiliziumschicht (3) als Maske dient und die zweite Implantationsdosis tiefer als die erste Implantationsdosis in den Halbleiterkörper eindringt;
e) der Halbleiterkörper wird mit einer zweiten Oxidschicht bedeckt, die um ein Vielfaches dicker ist als die erste Oxidschicht;
f) durch einen zweiten Fotoschritt werden in der zweiten Oxidschicht im Bereich der Transistorzellen und der am Rand liegende erste und zweite Zonen Kontaktlöcher bzw. ein Kontaktbereich die bis zu den Basiszonen (7) bzw. am Rand liegende zweite Zonen (17) reichen und zwischen den Transistorzellen und den am Rand liegende erste und zweite Zonen in der Polysilizium eine die Transistorzellen umgebende ringförmige Vertiefung erzeugt;
g) durch die Vertiefung werden Dotierstoffe in den Halbleiterkörper implantiert, die den entgegengesetzten Leitungstyp des Halbleiterkörpers haben, mit einer dritten Implantationsdosis, die geringer ist als die erste und zweite Implantationsdosen;
h) der Halbleiterkörper wird mit einer Metallschicht bedeckt;
i) die Metallschicht und die Polysiliziumschicht werden durch einen dritten Fotoschritt im Bereich der ringförmigen Vertiefung vollständig unterbrochen.

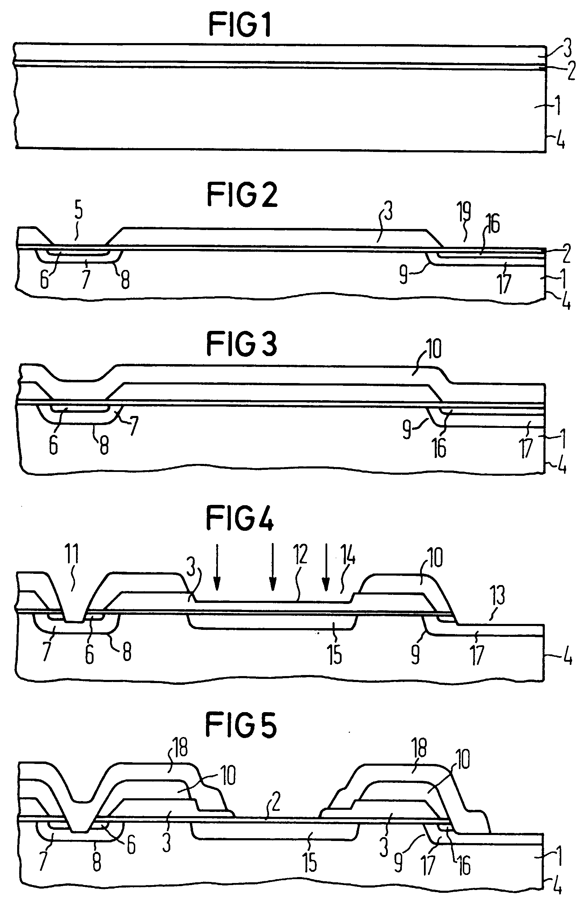

Die Erfindung wird anhand deines Ausführungsbeispiels in Verbindung mit den Fig. 1 bis 5 näher erläutert. Diese Figuren zeigen nicht alle, sondern nur die erfindungswesentlichen Verfahrensschritte. Gleiche Teile sind in den Figuren mit gleichen Bezugszeichen versehen.

In Fig. 1 ist ein Halbleiterkörper gezeigt und mit 1 bezeichnet. Er ist z. B. schwach n-leitend. Der Halbleiterkörper wird mit einer Oxidschicht 2 bedeckt, die als Gateoxid verwendet wird. Anschließend wird die Schicht 2 mit einer Polysiliziumschicht 3 bedeckt.

Die Polysiliziumschicht 3 wird in einem ersten Fotoschritt strukturiert, wobei Öffnungen 5 für die Transistorzellen und eine am Rand liegende Öffnung 19 für den Kanalstopper entstehen (Fig. 2). Diese Öffnungen haben schräge Flanken, so daß die Polysiliziumschicht 3 als Maske für die Herstellung der Sourcezonen 6 und der Basiszonen 7 bzw. der übereinanderliegenden Zonen 16, 17 des am Rand d4 liegenden Kanalstoppers 9 dienen kann. Sourcezonen 6, Basiszonen 7 und die Zonen 16, 17 werden in bekannter Art und Weise z. B. durch Implantation von Arsen- oder Phosphorionen bzw. Borionen erzeugt. Die Energie der Borionen ist dabei größer, so daß diese auch den abgeschrägten Teil der als Maske verwendeten Polysiliziumschicht 3 durchdringen und tiefer in den Halbleiterkörper 1 eindringen. Bei diesem Schritt werden Transistorzellen 8 und die Zonen 16, 17 erzeugt.

Als nächster Schritt (Fig. 3) wird eine zweite Oxidschicht 10 aufgebracht, die um ein Vielfaches dicker als die Oxidschicht 2 ist. Die Oxidschicht 10 bedeckt die gesamte Oberfläche des Halbleiterkörpers 1. In einem zweiten Fotoschritt wird die zweite Oxidschicht 10 strukturiert. Sie wird im Bereich der Transistorzellen 8 und der Zonen 16, 17 derart geöffnet, daß Kontaktlöcher 11 bzw. ein Kontaktbereich 13 entstehen, die bis zu den Basiszonen 7 bzw. zur Randzone 17 reichen. Beim gleichen Fotoschritt wird in der zweiten Oxidschicht 10 zwischen den Transistorzellen 8 und den Randzonen eine Öffnung 14 erzeugt, die die Transistorzellen 8 ringförmig umgibt. Der gleiche Ätzvorgang, der die Kontaktlöcher 11 und den Kontaktbereich 13 bis zur Oberfläche der Basiszonen 7 bzw. der Randzonen 17 öffnet, ätzt auch eine ringförmige Vertiefung 12 in die Polysiliziumschicht 3. Anschließend werden in die Oberfläche des Halbleiterkörpers z. B. Borionen implantiert, die eine ringförmige Zone 15 von dem Halbleiterkörper entgegengesetzten Leitungstyp erzeugen. Die angewandte Dosis ist geringer als die zur Herstellung der Sourcezonen 6 und der Basiszonen 7 bzw. der Randzonen 16, 17 verwendete Dosis. Daher ändert sich die Dotierung der Transistorzellen im Bereich des Kontaktloches nur unwesentlich. Zwischen der Zone 15 und den Transistorzellen ist die Oberfläche des Halbleiterkörpers im übrigen durch die Oxidschicht 10 gegen die Implantation von Ionen abgeschirmt (Fig. 4).

Anschließend wird auf die Oberfläche des Halbleiterkörpers eine Metallschicht 18, z. B. aus Aluminium aufgebracht. Diese Schicht bildet die Sourcekontakte für die Transistorzellen 8 und schafft die für einen Leistungs-MISFET unentbehrlichen Nebenschlüsse zwischen den Sourcezonen 6 und Basiszonen 7. Im Bereich des Kanalstoppers 9 kontaktiert die Metallschicht 18 die Randzonen 16, 17. In einem dritten und letztem Fotoschritt wird die Polysiliziumschicht 3 und die Metallschicht 18 über der Zone 15 vollständig unterbrochen (Fig. 5). Anschließend kann dann die gesamte Oberfläche noch mit einer Passivierungsschicht, z. B. aus Siliziumnitrid bedeckt werden. Dieser Schritt ist in den Figuren nicht dargestellt.

Gemäß einer Alternative kann auch die in Fig. 4 gezeigte Ionenimplantation erst nach der Unterbrechung der Polysiliziumschicht und der Metallschicht 16 (Fig. 5) vorgenommen werden. Hierbei wirkt dann die Metallschicht 18 als Maske.

Die mit den Transistorzellen 8 verbundene Metallschicht 18 wirkt zusammen mit dem mit ihr verbundenen Teil der Polysiliziumschicht 3 als Feldplatte. Die mit den Randzonen 16, 17 verbundene Metallschicht 18 wirkt in Verbindung mit der mit ihr verbundenen Polysiliziumschicht 3 als Kanalstopperelektrode. Da der die Randzone 17 begrenzende pn-Übergang durch seine Randlage infolge mechanischer Trennvorgänge z. B. durch Sägen sehr schlecht ist, ist hier ein relativ guter Kontakt zwischen dem Kanalstopper und dem Substrat des Halbleiterkörpers 1 gegeben. Die Zone 16 wirkt aus dem gleichen Grund auch nicht als Sourcezone. Die Zone 15 wirkt als Guard-Ring und liegt auf floatendem Potential.

## Patentansprüche

1. Verfahren zum Herstellen eines Leistungs-MISFET mit einem Halbleiterkörper, der ein Feld von Transistorzellen sowie mindestens eine Feldplatte und mindestens einen Kanalstopper aufweist, mit folgenden Schritten:
a) Der Halbleiterkörper (1) mit einem ersten Leitfähigkeitstyp wird mit einer ersten Oxidschicht (2) bedeckt, die als Gateoxid dient;
b) die erste Oxidschicht (2) wird mit einer Polysiliziumschicht (3) bedeckt;
c) in die Polysiliziumschicht (3) werden Öffnungen (5) für die Transistorzellen und eine am Rand (4) liegende Öffnung (19) für den Kanalstopper (9) durch einen ersten Fotoschritt strukturiert;
d) Sourcezonen (6) der Transistorzellen (8) und am Rand (4) des Halbleiterkörpers liegende erste Zonen (16) einer erstes Leitfähigkeitstyps werden mit einer ersten Implantationsdosis erzeugt, und Basiszonen (7) der Transistorzellen (8) und am Rand (4) des Halbleiterkörpers liegende zweite Zonen (16) eines zweiten zum ersten Leitfähigkeitstyp entgegengesetzten Leitfähigkeitstyps werden mit einer zweiten Implantationsdosis erzeugt, wobei die strukturierte Polysiliziumschicht (3) als Maske dient und die zweite Implantationsdosis tiefer als die erste Implantationsdosis in den Halbleiterkörper eindringt;
e) der Halbleiterkörper wird mit einer zweiten Oxidschicht (10) bedeckt, die um ein Vielfaches dicker ist als die erste Oxidschicht (2);
f) durch einen zweiten Fotoschritt werden in der zweiten Oxidschicht (10) im Bereich der Transistorzellen (8) und der am Rand liegende erste und zweite Zonen (16, 17) Kontaktlöcher (11) bzw. ein Kontaktbereich (13) die bis zu den Basiszonen (7) bzw. am Rand liegende zweite Zonen (17) reichen und zwischen den Transistorzellen (8) und den am Rand liegende erste und zweite Zonen (16, 17) in der Polysilizium eine die Transistorzellen (8) umgebende ringförmige Vertiefung (12) erzeugt;
g) durch die Vertiefung (12) werden Dotierstoffe in den Halbleiterkörper implantiert, die den entgegengesetzten Leitungstyp des Halbleiterkörpers haben, mit einer dritten Implantationsdosis, die geringer ist als die erste und zweite Implantationsdosen;
h) der Halbleiterkörper wird mit einer Metallschicht (18) bedeckt;
i) die Metallschicht (18) und die Polysiliziumschicht (3) werden durch einen dritten Fotoschritt im Bereich der ringförmigen Vertiefung (12) vollständig unterbrochen.

2. Verfahren nach Anspruch 1,
**dadurch gekennzeichnet**,
daß der Verfahrensschritt g) nach den Verfahrensschritten a) und i) durchgeführt wird.

3. Verfahren nach Anspruch 1 oder 2,
**dadurch gekennzeichnet**,
daß als letzter Verfahrensschritt der Leistungs-MISFET mit einer Passivierungsschicht bedeckt wird.

## Claims

1. Method of fabricating a power MISFET having a semiconductor body which has an array of transistor cells and also at least one field plate and at least one channel stopper, having the following steps:
a) the semiconductor body (1) having a first conductivity type is covered with a first oxide layer (2), which serves as gate oxide;
b) the first oxide layer (2) is covered with a polysilicon layer (3);
c) openings (5) for the transistor cells and an opening (19) for the channel stopper (9), which opening (19) is situated at the edge (4), are structured in the polysilicon layer (3) by means of a first photographic step;
d) source zones (6) of the transistor cells (8) and first zones (16) of a first conductivity type, which first zones (16) are situated at the edge (4) of the semiconductor body, are produced with a first implantation dose, and base zones (7) of the transistor cells (8) and second zones (16) of a second conductivity type opposite to the first conductivity type, which second zones (16) are situated at the edge (4) of the semiconductor body, are produced with a second implantation dose, the structured polysilicon layer (3) serving as mask and the second implantation dose penetrating the semiconductor body to a greater depth than the first implantation dose;
e) the semiconductor body is covered with a second oxide layer (10), whose thickness is a multiple of that of the first oxide layer (2);
f) a second photographic step is carried out such that, in the second oxide layer (10), contact holes (11) and a contact region (13) are produced in the region of the transistor cells (8) and, respectively, of the first and second zones (16, 17) situated at the edge, which contact holes (11) and contact region (13) extend as far as the base zones (7) and, respectively, second zones (17) situated at the edge, and an annular depression (12) surrounding the transistor cells (8) is produced in the polysilicon between the transistor cells (8) and the first and second zones (16, 17) situated at the edge;
g) dopants having the opposite conductivity type to that of the semiconductor body are implanted through the depression (12) into the semiconductor body, with a third implantation dose, which is lower than the first and second implantation doses;
h) the semiconductor body is covered with a metal layer (18);
i) the metal layer (18) and the polysilicon layer (3) are completely interrupted in the region of the annular depression (12) by means of a third photographic step.

2. Method according to Claim 1,
characterized in that the method step g) is carried out after the method steps a) and i).

3. Method according to Claim 1 or 2,
characterized in that the last method step carried out is to cover the power MISFET with a passivation layer.

## Revendications

1. Procédé pour la fabrication d'un MISFET de puissance avec un corps semi-conducteur, qui présente un champ de cellules transistors ainsi qu'au moins une magnétorésistance et au moins un stoppeur de canal, avec les étapes suivantes :
a) le corps semi-conducteur (1) avec un premier type de conductibilité est recouvert avec une première couche d'oxyde (2), qui sert d'oxyde de grille ;
b) la première couche d'oxyde (2) est recouverte avec une couche de polysilicium (3) ;
c) dans la couche de polysilicium (3) sont structurées, des ouvertures (5) pour les cellules transistors et une ouverture (19) se trouvant au bord (4) pour le stoppeur de canal (9), par l'intermédiaire d'une première étape photo ;
d) les zones de source (6) des cellules transistors (8) et les premières zones (16) d'un premier type de conductibilité se trouvant en bordure (4) du corps semi-conducteur sont fabriquées avec une première dose d'implantation, et les zones de base (7) des cellules transistors (8) et les deuxièmes zones (16), d'un deuxième type de conductibilité de signe opposé au premier type de conductibilité, se trouvant en bordure (4) du corps semi-conducteur sont fabriquées avec une deuxième dose d'implantation, la couche de polysilicium (3) structurée servant de masque et la deuxième dose d'implantation pénétrant de façon plus profonde que la première dose d'implantation dans le corps semi-conducteur;
e) le corps semi-conducteur est recouvert d'une deuxième couche d'oxyde (10), qui est bien plus épaisse que la première couche d'oxyde (2) ;
f) grâce à une deuxième étape photo sont fabriquées, dans la deuxième couche d'oxyde (10) dans le domaine des cellules transistors (8) et des première et deuxième zones (16, 17) se trouvant au bord, des trous de contact (11), respectivement un domaine de contact (13), qui s'étendent jusqu'aux zones de base (7), respectivement jusqu'aux deuxième zones (17) se trouvant au bord, et entre les cellules transistors (8) et les première et deuxième zones (16, 17) se trouvant au bord dans le polysilicium, une cavité (12) en forme d'anneau entourant les cellules transistors (8) ;
g) grâce à la cavité (12), des substances dopantes sont implantées dans le corps semi-conducteur, lesdites substances ayant le type de conductibilité de signe opposé au corps semi-conducteur, avec une troisième dose d'implantation qui est plus faible que les première et deuxième doses d'implantation;
h) le corps semi-conducteur est recouvert d'une couche métallique (18);
i) la couche métallique (18) et la couche de polysilicium (3) sont complètement interrompues dans le domaine de la cavité (12) en forme d'anneau par l'intermédiaire d'une troisième étape photo.

2. Procédé selon la revendication 1,
caractérisé en ce que
l'étape g) du procédé est exécutée après les étapes a) et i) du procédé.

3. Procédé selon la revendication 1 ou 2,
caractérisé en ce que
comme dernière étape du procédé, le MISFET de puissance est recouvert d'une couche de passivation.
